# EUROPÄISCHE PATENTANMELDUNG

(11) **EP 0 952 763 A2**
(43) Veröffentlichungstag der Anmeldung: **27.10.1999**
(21) Anmeldenummer: 99440052.1
(22) Anmeldetag: 12.03.1999
(51) Int. Cl.: H05K 5/00

(54) **Baugruppe mit elektronischen Bauelementen**

(30) Priorität: 22.04.1998 DE 19817850
(71) Anmelder: ALCATEL, 75008 Paris (FR)
(72) Erfinder: Fechtig, Helmut, 79848 Bonndorf-Wellenbrink (DE); Neukum, Heinz, 79780 Stühlingen 11 (DE)
(74) Vertreter: Brose, Gerhard, Dipl.-Ing.

(57) **Zusammenfassung**

Die Erfindung betrifft eine Baugruppe mit elektronischen Bauelementen, die auf einem Träger montiert und entsprechend einer vorgegebenen Schaltung elektrisch miteinander verbunden sind. Eine derartige Baugruppe, die sich durch besondere Variabilität, Montagefreundlichkeit, Kompaktheit und Einsetzbarkeit für große Ströme auszeichnet, ist dadurch gekennzeichnet, daß der Träger als Kunststoffspritzteil (1) ausgebildet ist, in den Flachstecker (3) zur Aufnahme der Bauelemente einsetzbar sind.

## Beschreibung

Die Erfindung betrifft eine Baugruppe mit elektronischen Bauelementen gemäß dem Oberbegriff des Anspruchs 1. Baugruppen mit elektronischen Bauelementen für Massenprodukte müssen einerseits montagefreundlich und kostengünstig sein und andererseits problemlos Änderungen bzw. Verbesserungen bei sehr großer Variantenvielfalt gestatten. Bekannt ist, als Träger für die verschiedenen Bauelemente eine Leiterplatte zu verwenden. Dabei werde die Bauteile auf der Leiterplatte zu einer Baugruppe zusammengesteckt und verlötet. Nachteilig ist neben dem erheblichen Montage- und Materialkostenaufwand vor allem die Beschränkung des Querschnittes der Lötbahnen auf relativ geringe Werte. Dadurch ist die Leiterplattenvariante für große Ströme im Ampere-Bereich nur bedingt einsetzbar. Darüber hinaus sind entweder sehr große Abstände zwischen den einzelnen Bauelementen oder zusätzliche lsolationsstege erforderlich. Die Ausschußrate ist relativ hoch, da durch das Zusammenlöten Leiterbahnen losgerissen werden können. Zur Realisierung verschiedener Schaltkreise und Baugruppendimensionierungen sind jeweils spezielle Leiterplatten erforderlich.

Der Erfindung liegt die Aufgabe zugrunde, eine Baugruppe mit elektronischen Bauelementen der gattungsgemäßen Art anzugeben, die sich durch Variabilität, Montagefreundlichkeit, Kostenersparnis, Einsetzbarkeit für größere Ströme und eine verringerte Ausschußrate auszeichnet.

Erfindungsgemäß wird die Aufgabe mit den kennzeichnenden Merkmalen des Anspruchs 1 gelöst. Das Kunststoffspritzteil ist wesentlich preisgünstiger als die Leiterplatte, wobei problemlos Ausformungen jeglicher Art realisierbar sind. Die Flachstecker zur Aufnahme der Bauelemente lassen sich auf technologisch einfache Weise in das Kunststoffspritzteil einsetzen. Lötbahnen und Lötstellen entfallen dadurch. Hohe Ströme können bedenkenlos realisiert werden. Je nach Steckerpositionierung können auf einem Kunststoffspritzteil ganz unterschiedliche Schaltungen aufgebaut werden.

Bevorzugt sind die Flachstecker gemäß Anspruch 2 in das Kunststoffspritzteil einpreßbar ausgebildet. Dadurch ergibt sich bei einfacher Montage eine robuste Baugruppe, die gegen mechanische Beschädigungen weitgehend geschützt ist.

Anspruch 3 charakterisiert eine vorteilhafte Ausführungsform zur Befestigung der Flachstecker auf dem Kunststoffspritzteil. Die Fußausformungen der Flachstecker garantieren in Verbindung mit, insbesondere auf Klemmsitz, angepaßten Vertiefungen des Kunststoffspritzteiles eine feste und gegebenenfalls dennoch lösbare Verbindung zwischen den Flachsteckern und dem Kunststoffspritzteil.

Dazu weisen die Fußausformungen vorzugsweise L-förmige Umbiegungen entsprechend Anspruch 4 auf. Diese Umbiegungen und gegebenenfalls widerhakenartige Fußausformungen ermöglichen in einfacher Weise eine richtig orientierte Montage der nicht symmetrischen Flachstecker in Verbindung mit einem überaus widerstandsfähigen Paßsitz.

Die Flachstecker sind gemäß Anspruch 5 bevorzugt mit genormten Flachsteckerfahnen ausgestattet. Zu den Steckhülsen diverser Bauelemente können die Fahnen beispielsweise einen Querschnitt von 2,8 mm mal 0,8 mm aufweisen. Möglich sind aber auch weitere Größenordnungen, deren Normlängsmaße des Querschnitts gestaffelt 4,8 mm, 6,3 mm usw. betragen können.

Durch die lsolationsstege zwischen den Flachsteckerfahnen gemäß Anspruch 6 ergibt sich ein überaus kompakter Aufbau der Baugruppe. Da die lsolationsstege sowie sämtliche andere Ausformungen des Kunststoffspritzteiles mit dessen Matrize vorgegeben werden kann, ist eine separate Montage dieser Isolationsstege - im Gegensatz zur Leiterplattenvariante - nicht notwendig.

Vorteilhafterweise ist entsprechend Anspruch 7 eine beidseitige Bauelementeanordnung bezüglich des Kunststoffspritzteiles vorgesehen. Die elektrische Verbindung zwischen den beiden Seiten kann dabei beispielsweise durch zwei Lötstellen, die Steckerfüße und Anschlüsse der auf der Gegenseite zu montierenden Bauelemente verbinden, realisiert sein.

Beispielsweise kann gemäß Anspruch 8 auf der einen Seite die Montage von Bauelementen für eine Motorbeschaltung und auf der anderen Seite ein größerer Kondensator angeordnet sein. Bekannt ist eine solche Baugruppe als Verschalteinheit mit Kondensator für einen Jalousiemotor, insbesondere Jalousie-Mittelmotor.

Die Erfindung wird nachfolgend anhand eines figürlich dargestellten Ausführungsbeispiels näher erläutert.

Es zeigen:

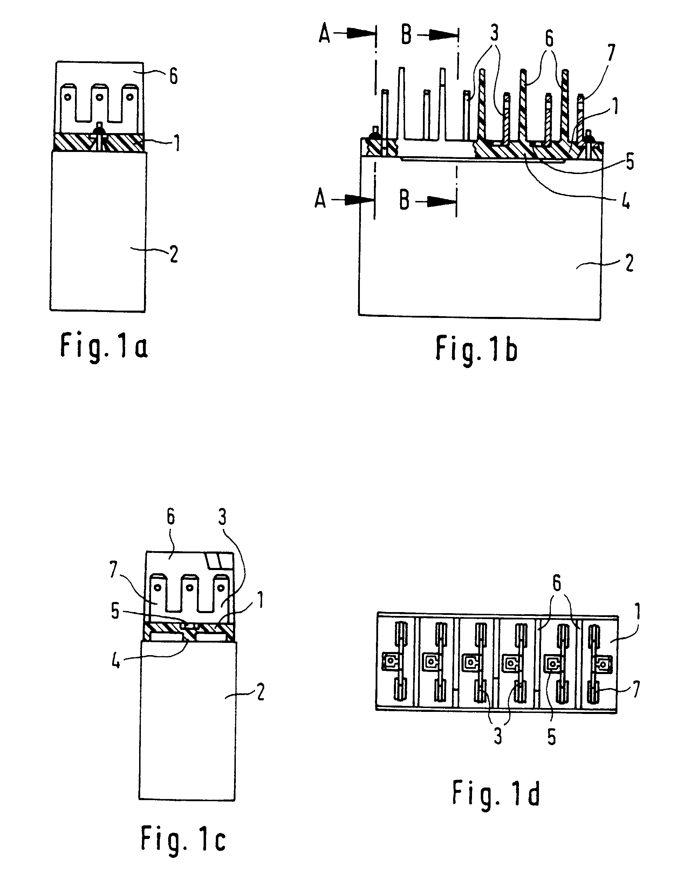

Figur 1a eine Schnittdarstellung gemäß der Linie A-A aus Figur 1b einer erfindungsgemäßen Baugruppe,
Figur 1b eine Vorderansicht der Baugruppe in teilweise geschnittener Darstellung,
Figur 1c eine Schnittdarstellung gemäß der Linie B-B in Figur 1b und
Figur 1d eine Draufsicht auf die Baugruppe.

Die in den Figuren 1a bis 1d dargestellte Baugruppe ist Bestandteil eines Jalousie-Mittelmotors. Im wesentlichen besteht die Baugruppe aus einem Kunststoffspritzteil 1, einem an der Unterseite des Kunststoffspitzteiles 1 angelöteten Kondensator2 und oberseitig montierten Flachsteckern 3. Die Flachstecker 3 sind mit Fußausformungen 5 in entsprechende Vertiefungen 4 des Kunststoffspritzteiles 1 eingepreßt. Zwischen den Flachsteckern 3 sind jeweils deren Flachsteckerfahnen 7 überragende Isolationsstege 6 als Ausformungen des Kunststoffspritzteiles 1 angeordnet. Die Steckerfahnen 7 dienen als Aufnahmen für entsprechende Steckerhülsen nicht dargestellter Bauelemente, wie beispielsweise Spulen und Schaltern. Durch die Kunststoffspritzteile 1-/Flachstecker 3-Ausbildung ist die Baugruppe überaus kompakt, robust und für verschiedene Schaltkreise und Baugruppendimensionierungen gleichermaßen geeignet.

Die Erfindung beschränkt sich nicht auf das vorstehend angegebene Ausführungsbeispiel. Vielmehr ist eine Anzahl von Varianten denkbar, welche auch bei grundsätzlich anders gearteter Ausführung von den Merkmalen der Erfindung Gebrauch machen.

## Patentansprüche

1. Baugruppe mit elektronischen Bauelementen, die auf einem Träger montiert und entsprechend einer vorgegebenen Schaltung elektrisch miteinander verbunden sind, dadurch gekennzeichnet, daß der Träger als Kunststoffspritzteil (1) ausgebildet ist, in den Flachstecker (3) zur Aufnahme der Bauelemente einsetzbar sind.

2. Baugruppe nach Anspruch 1, dadurch gekennzeichnet, daß die Flachstecker (3) in das Kunststoffspritzteil (1) einpreßbar sind.

3. Baugruppe nach einem der vorangehenden Ansprüche, dadurch gekennzeichnet, daß das Kunststoffspritzteil (1) Vertiefungen (4) für Fußausformungen (5) der Flachstecker (3) aufweist.

4. Baugruppe nach Anspruch 3, dadurch gekennzeichnet, daß die Fußausformungen (5) L-förmige Umbiegungen aufweisen.

5. Baugruppe nach einem der vorangehenden Ansprüche, dadurch gekennzeichnet, daß die Flachstecker (3) genormte Falchsteckerfahnen (7) aufweisen.

6. Baugruppe nach einem der vorangehenden Ansprüche, dadurch gekennzeichnet, daß das Kunststoffspritzteil (1) zwischen Flachsteckerfahnen (7) aufragende Isolationsstege (6) aufweist.

7. Baugruppe nach einem der vorangehenden Ansprüche, dadurch gekennzeichnet, daß das Kunststoffspritzteil (2) beidseitig mit Bauelementen bestückbar ausgebildet ist.

8. Baugruppe nach einem der vorangehenden Ansprüche, dadurch gekennzeichnet, daß das Kunststoffspritzteil (1) mit auf der einen Seite eingepreßten Flachsteckern (3) zur Aufnahme von Bauelementen für eine Motorbeschaltung und auf der anderen Seite angelötetem Kondensator (2) ausgebildet ist.
